# EUROPEAN PATENT APPLICATION

(11) **EP 0 561 386 A1**
(43) Date of publication of application: **22.09.1993**
(21) Application number: 93104360.8
(22) Date of filing: 17.03.1993
(51) Int. Cl.: H03K 17/08

(54) **Semiconductor device**

(30) Priority: 18.03.1992 JP 62254/92; 24.03.1992 JP 65960/92; 19.03.1992 JP 125214/92
(71) Applicant: FUJI ELECTRIC CO., LTD., Kawasaki-shi Kanagawa 210 (JP)
(72) Inventor: Ogawa, Shogo, c/o Fuji Electric Co., Ltd., Kawasaki-shi, Kanagawa (JP); Miyasaka, Tadashi, c/o Fuji Electric Co., Ltd., Kawasaki-shi, Kanagawa (JP); Kobayashi, Shinichi, c/o Fuji Electric Co., Ltd., Kawasaki-shi, Kanagawa (JP); Kuwabara, Kesanobu, c/o Fuji Electric Co., Ltd., Kawasaki-shi, Kanagawa (JP)
(74) Representative: Grünecker, Kinkeldey, Stockmair & Schwanhäusser Anwaltssozietät

(57) **Abstract**

A semiconductor device includes an insulated gate semiconductor portion (2) having a gate electrode (2g); an overcurrent limiting portion (12,13) for judging an overcurrent state of the insulated gate semiconductor portion (2) to make it possible to change a gate voltage applied to the gate electrode (2g); and a driving portion (30) for driving the insulated gate semiconductor portion (2). The driving portion (30) includes a driving section (20) for supplying a control voltage to the insulated gate semiconductor device (2) correspondingly to an input signal (I) supplied to the driving portion; and a comparing section (40) for comparing the gate voltage (V_{G}) with a predetermined reference voltage (Vo). The semiconductor device may further include a gate control relaxation section (141) for relaxing a rate of change of the gate voltage (V_{G}) applied to the gate electrode.

## Description

### BACKGROUND OF THE INVENTION

The present invention relates to a semiconductor device having an insulated gate transistor such as an insulated gate bipolar transistor (IGBT) used as a main switching element of a power transformer.

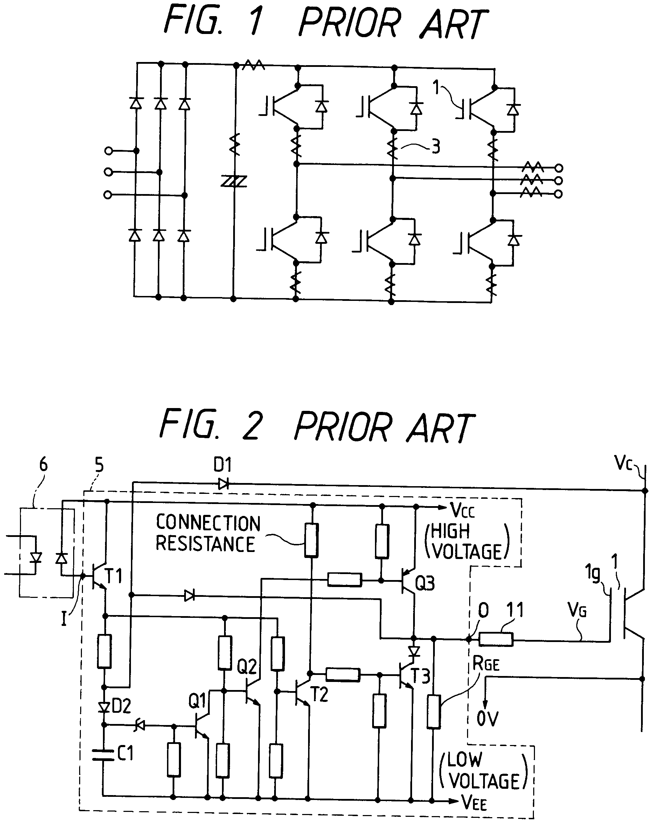

Figs. 1 and 2 show examples of semiconductor devices of the type capable of being monitored for and protected from an overcurrent. That shown in Fig. 1 is a device having a plurality of IGBTs 1 connected to each other. A current flowing in each of the IGBTs 1 is measured by using a current transformer (CT) 3. Short-circuit currents are respectively judged by the detection values of the CTs 3, by which the respective IGBTs 1 are prevented from falling into overcurrent states. This method of measuring short-circuit currents on the basis of the CTs 3, however, has a problem in that semiconductor devices such as IGBTs, in most cases, have been already destroyed when such overcurrent states are judged from the results of measurements by the CTs 3.

That shown in Fig. 2 is a semiconductor device improved in this problem. In the semiconductor device, an output voltage V_{c} from an IGBT 1 is introduced into a soft cutting-off circuit 5 so that the IGBT 1 is turned off on the basis of the output voltage V_{c}. An input signal I is supplied to the soft cutting-off circuit 5 through a photo coupler 6, so that a control voltage V1 is outputted from an output O via transistors T1, T2 and T3 on the basis of the input signal I. Then, the control voltage V1 passes through a gate resistor 11 to form a gate voltage v_{G} which is to be applied to a gate electrode 1g of the IGBT 1.

When, in the soft cutting-off circuit 5, the transistor Q1 is turned on, the transistor Q3 is turned off via the transistor Q2. As a result, a high voltage v_{cc} supplied as the control voltage V1 is cut off, so that the control voltage V1 is gradually reduced through cutting-off resistors RGg and, accordingly, the IGBT 1 is soft cut off. Because the soft cutting-off circuit 5, as described above, has a function capable of gradually reducing the control voltage V1, the noise production, the voltage pulsation, and so on, can be prevented at the time of the cutting-off of the IGBT 1. In the device shown in Fig. 2, the output voltage V_{c} from the IGBT 1 is supplied as a cutting-off input of the soft cutting-off circuit 5. That is, the output voltage V_{c} is connected to the base of the transistor Q1 through a diode D1. Accordingly, in the case where the IGBT 1 is in an on state, a current flows in the IGBT 1 through the diode D1 on the basis of the high voltage Vcc supplied from the transistor T1. At this time, the transistor Q1 is off. When an overcurrent further flows in the IGBT 1, a voltage drop in the IGBT 1 increases so that the output voltage V_{c} exceeds a predetermined voltage. Hence, the high voltage V_{cc} supplied through the transistor T1 is supplied to a capacitor C1 connected to the base of the transistor Q1 via a diode D2. As a result, the base voltage of the transistor Q1 becomes high, so that the transistor Q1 is turned on, and thus the above-mentioned soft cutting-off is completed.

The device using the above-mentioned soft cutting-off circuit 5 is quick in overcurrent detecting speed, and it can automatically switch the IGBT 1 from an on state to an off state. Accordingly, the device is adapted for protecting the IGBT 1 from damaging, or the like, by an overcurrent. It is however necessary that insulating characteristic corresponding to the high voltage applied to the IGBT 1 is given to the device per se, including the soft cutting-off circuit 5, because the output voltage V_{c} from the IGBT 1 is referred to in the constructure of the soft cutting-off circuit 5. There arises a further problem in that the soft cutting-off circuit 5 may malfunction for the reason of catching the change of the output voltage v_{c} at the time of the on/off operation of the IGBT 1. In addition, there arises a problem in that wiring is complicated because the connection to the collector of the IGBT 1 is required for referring to the output voltage V_{c}.

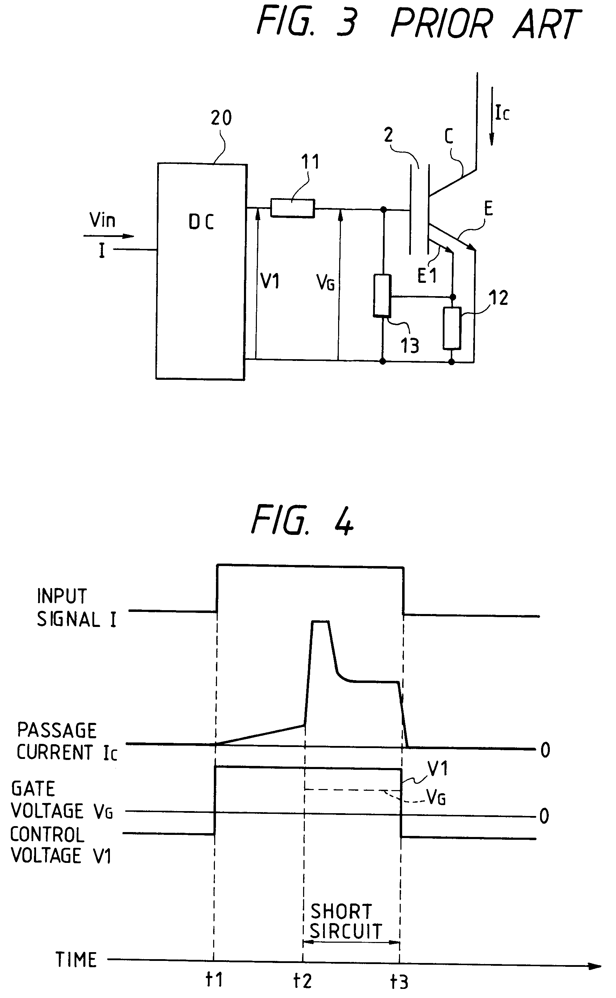

That shown in Fig. 3 is a device to cope with the above-mentioned problem. A sense-including IGBT 2 in which a sense terminal E1 is provided for detecting the current flowing in the IGBT, is employed in the device. In this sense-including IGBT 2, a current corresponding to the current I_{c} flowing in the IGBT flows in the sense terminal E1. Accordingly, an overcurrent can be prevented by connecting a detection resistor 12 to the sense terminal E1 and by limiting the gate voltage V_{c} through an overcurrent limiting circuit 13 using an MOS and the like on the basis of the voltage drop across the detection resistor 12. The operation of the device using the sense-including IGBT 2 will be described on the basis of a timing chart shown in Fig. 4. First at a point of time T1, the level of the input signal I supplied to a driving circuit 20 becomes high so that the IGBT 2 is turned on. Accordingly, the control voltage V1 of a high voltage is outputted from the driving circuit 20 to form a gate voltage V_{G} to be applied to a gate electrode 2g through a gate resistor 11. When, at a point of time t2, the passage current I_{c} flowing in the IGBT 2 increases rapidly with occurrence of short-circuit, the voltage drop across the detection resistor 12 becomes high. Hence, the overcurrent limiting circuit 13 operates to reduce the gate voltage V_{G}. Accordingly, the passage current I_{c} decreases, so that the IGBT 2 is protected from damaging caused by an overcurrent. When, at a point of time t3, the level of the input signal I becomes low, the control voltage V1 and the gate voltage V_{G} are lowered to turn the IGBT 2 off.

The IGBT can be projected from an overcurrent, by using the sense-including IGBT 2 as described above. The driving circuit 20, however, continuously supplies the control voltage V1 corresponding to the input signal I even in the case where an operation of limiting the overcurrent to a predetermined current level is made. Accordingly, the IGBT 2 being in a state where an overcurrent flows therein, is continuously controlled to this state. Hence, when the current flowing in the IGBT 2 is reduced by the some cause to lower the voltage drop across the detection resistor 12 to thereby stop the operation of the overcurrent limiting circuit 13, an overcurrent flows in the IGBT 2 again. That is, the two operations of permitting the overcurrent to flow in the IGBT 2 and limiting the overcurrent are repeated. As a result, it is supposed that device destruction may be reached irrespective of the existence of the overcurrent limiting circuit 13. There arises a further problem in that the operation in the abnormal state where the overcurrent flows in the IGBT 2 is continued.

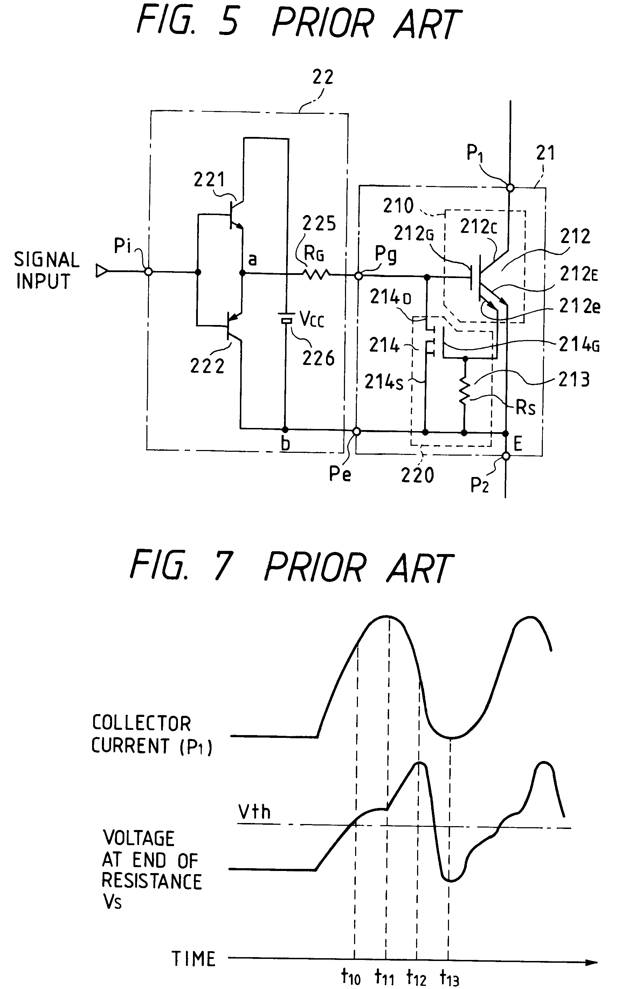

Fig. 5 shows another example of the structure of a conventional semiconductor device having a switching portion 21 using an insulated gate transistor. In this example, the switching portion 21 is constituted by using an IGBT (insulated gate bipolar transistor, hereinafter called IGBT) 212 which is a bipolar transistor having an insulated gate as a switching element 210. The IGBT 212 is provided with a current-sense IGBT. Accordingly, a current equal or proportional to the current flowing between a collector terminal 212C of the IGBT 212 connected to a high electric potential load terminal P1 and an emitter terminal 212E of the IGBT 212 connected to a low electric potential load terminal P2, flows in a sense emitter terminal 212e which is a current-sense terminal of the IGBT. Further in the switching portion 21, a current limiting circuit 220 is formed to protect the IGBT 212 from overcurrent. The current limiting circuit 220 is composed of a sense resistor 213 which is a current-detection resistor inserted between the sense emitter terminal 212e of the IGBT 212 and the load terminal P2, and an MOSFET 214 having a gate electrode 214G to which a voltage produced in the sense resistor 213 is applied. A drain 214D of the MOSFET 214 is connected to a line which extends from an input terminal Pg for receiving a gate voltage signal Vg supplied to the switching portion 21 to control the switching element 210, to a gate electrode 212G of the IGBT 212. A source 214S of the MOSFET 214 is connected to the load terminal P2. Accordingly, when an overcurrent flows in the IGBT 212 so that the dropped voltage produced in the current-sense resistor 213 reaches a threshold of the MOSFET 214, the MOSFET 214 becomes so conductive that the gate voltage signal Vg applied to the input terminal Pg is lowered. Hence, the voltage applied to the gate electrode 212G of the IGBT 212 is reduced, so that the IGBT 212 makes a current limiting operation. Accordingly, the state where an overcurrent flows is avoided, so that a limited current is provided by the IGBT 12. Thus, the switching element 210 is protected from element destruction caused by an overcurrent.

The above-mentioned switching portion 21 is controlled by a gate driving circuit 22 for generating the gate voltage signal Vg. In this example, the gate driving circuit 22 uses an NPN transistor 221 as an on-side output switch and a PNP transistor 222 as an off-side output switch. In order to constitute the gate driving circuit, of course, the PNP transistor and the like may be replaced by a switching element such as a field-effect transistor.

In the gate driving circuit 22, a gate resistor 125 is further provided between an intermediate point a between the two output switches 221 and 222 and the input terminal Pg connected to a non-driving element, that is, the switching element 210. The load terminal P2 on the low electric potential side of the switching portion 21, that is, the emitter side of the IGBT 212, is connected to the low electric potential side b of the gate driving circuit 22. Further, a driving electric source 226 is provided to supply a source voltage Vcc to the low electric potential side b to produce the gate voltage signal Vg.

When, in the above-mentioned gate driving circuit 22, the input signal supplied to the input terminal P1 connected to the respective bases of the output switches 221 and 222 is turned on (to be made High), the on-side output NPN transistor 221 is turned on so that the driving source voltage Vcc is applied to the input terminal Pg of the switching portion 21 to thereby turn on the switching element 210. When, on the contrary, the input signal of the driving circuit 22 is turned off (to be made Low), the off-slide output PNP transistor 222 is turned on so that a low electric potential is applied to the input terminal Pg of the switching portion 21. Accordingly, the switching element 210 is turned off.

Thus, by use of the gate driving circuit 21, it is possible to control the IGBT 212 of the switching portion having the current limiting circuit 220 in accordance with the on/off of the input signal. when the current between the collector 212C and emitter 212E of the IGBT 212 falls in an overcurrent state, the drop voltage across the sense resistor 213 increases to thereby turn on the current-limiting MOSFET 214. As a result, the gate voltage applied to the IGBT 212 is reduced to thereby protect the IGBT 212.

Even during the aforementioned operation of limiting the overcurrent to a predetermined current level, however, the gate driving circuit 22 continuously supplies the gate voltage signal to the input terminal Pg of the switching portion 21 in accordance with the input signal. Accordingly, the switching portion 21 being in a state where an overcurrent flows, is continuously controlled so as to be the state as it is. Therefore, when the currents supplied to the load terminals P1 and P2 are reduced by some cause so that the drop voltage across the sense resistor 213 is reduced to turn off the MOSFET 214, an overcurrent flows in the IGBT 212 again so that the aforementioned operation must be repeated. As a result, it is supposed that the state of element destruction is reached though the overcurrent limiting circuit is provided. There is also a problem in that the operation is continued in the abnormal state where an overcurrent flows.

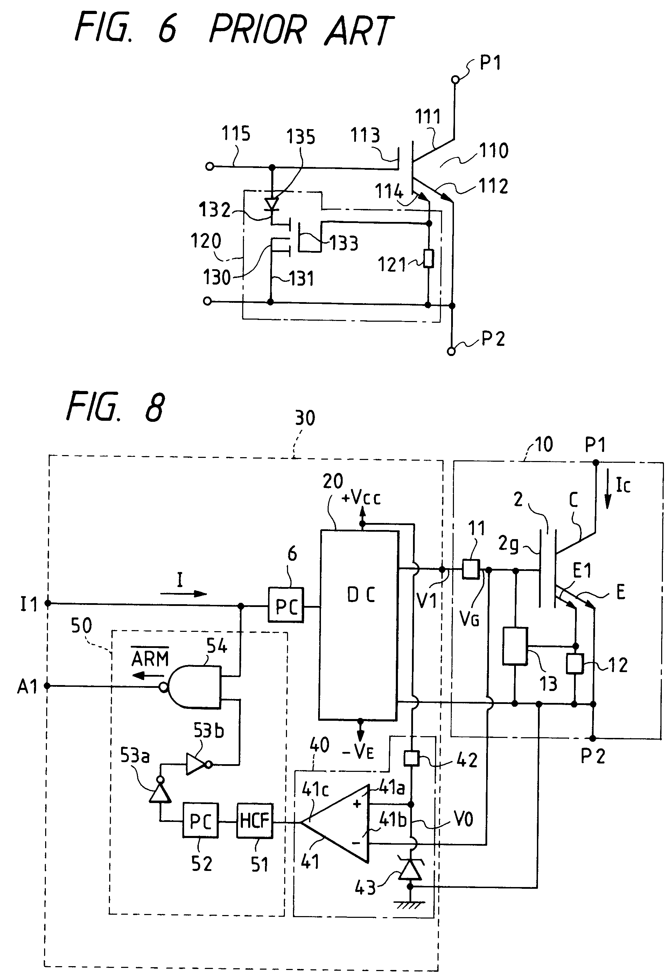

Fig. 6 shows still another circuit configuration of a semiconductor device having a conventional overcurrent protection circuit.

This semiconductor device is a semiconductor device using as insulated gate bipolar transistor (IGBT) 110 as a switching element, and is a power semiconductor device which can control a large current under a high withstanding voltage.

In this semiconductor device, an external terminal P1 which becomes a high electric potential is connected to a collector 111 of the IGBT 110, and an external terminal P2 which becomes a low electric potential is connected to an emitter 112 of the IGBT 110, so that a current to a circuit connected to the external terminals P1 and P2 can be controlled by controlling a gate voltage Vg applied to a gate 113 of the IGBT 110. Further, in this embodiment, the IGBT 110 has a sense emitter 114 for current detection in addition to the emitter 112 connected to the external terminal P2. This sense emitter 114 is an emitter of a current sense IGBT additionally built in the main IGBT 110 for controlling a large current, and the sense emitter 114 is connected to the external terminal P2 through a current sense resistor 121. Therefore, a current the same as or proportional to a current flowing between the collector 111 and the emitter 112 of the IGBT 110 flows from this sense emitter 114.

Further, in this semiconductor device, a current limitation circuit 120 is provided to prevent elements from being broken by an overcurrent flowing into the IGBT 110. The current limitation circuit 120 in a conventional device is constituted by an n-channel MOSFET 130 connected through a reverse-current blocking diode 135 to a gate driving circuit 15 for driving the gate 113 of the IGBT 110. This n-channel MOSFET 130 has a source 131 connected to the external terminal P2 which becomes a low electric potential, a drain 132 connected to the gate driving circuit 115 through the reverse-current blocking diode 135, and a gate 133 to which a drop voltage Vs across the current sense resistor 121 is applied.

In the current limitation circuit 20, if an overcurrent flows into the IGBT 110 and a predetermined current flows into the current sense resistor 121 from the sense emitter 114, a drop voltage across the current sense resistor 121 becomes over a threshold value of the MOSFET 130. Consequently, the MOSFET is turned on, so that a current supplied to the gate 113 of the IGBT 110 from the gate driving circuit 115 is bypassed through the MOSFET 130, and the gate voltage Vg applied to the gate 113 is therefore reduced to thereby limit a current passing through the IGBT 110.

As has been described, a semiconductor device having a current limitation circuit can protect a switching element from an overcurrent, but in a conventional circuit, a current is dropped suddenly or a current value oscillates when current limitation is performed in the switching element. In order to perform stable current limitation, therefore, it is important to suppress such oscillation of the current value.

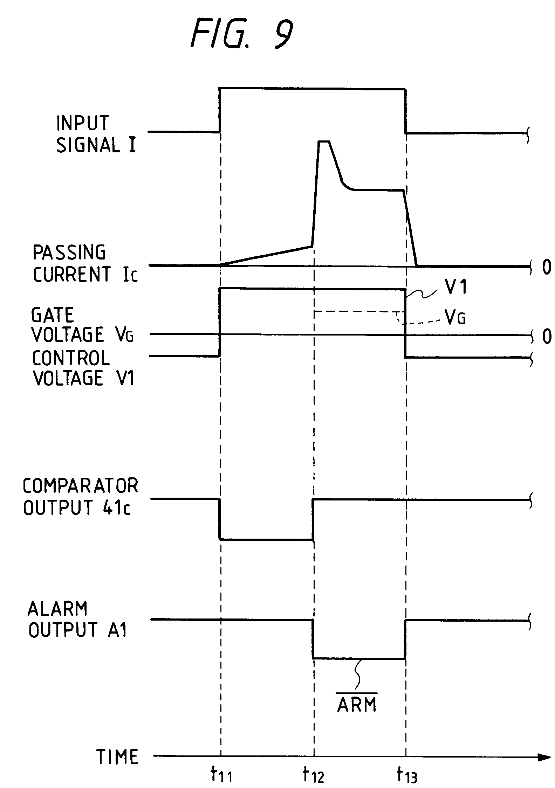

Fig. 7 shows a collector current flowing in the external terminal P1, and a drop voltage Vs produced across the current sense resistor 121 in the case where a large current flows in a device using such a current limitation circuit as shown in Fig. 6. First, if a large current flows into the IGBT 110, a current proportional to this large current flows from the sense emitter 114, and the drop voltage Vs across the current sense resistor 121 is hence raised. At a point of time t10, if the drop voltage Vs is over a threshold voltage Vth of the MOSFET 130, the MOSFET 130 is turned on. However, the collector current begins to decrease at a point of time t11 where a slight overcurrent flows because of the delay in response of the operation of the MOSFET 130. At this time, particularty in an element for controlling a large current, a voltage of ℓ x di/dt which is an inductance load voltage is produced in the current sense resistor 121 by the time differential (di/dt) of a suddenly dropped current, wherein l represents the inductance of the circuit. Consequently at a point of time t12, the MOSFET 130 is biased forward by this voltage and the voltage between the drain 132 and the source 131 becomes low. The gate voltage Vg applied to the IGBT 110 is therefore lowered so that the IGBT 110 is turned off at a point of time t13.

Thus, the IGBT 110 is turned off and no overcurrent flows. As a result, however, the drop voltage Vs across the current sense resistor 121 is lowered so that the MOSFET 130 is turned off. Accordingly, the gate voltage Vg returns to its predetermined value so that the IGBT 110 is turned on again to a state in which an overcurrent flows. Thus, in a conventional current limitation circuit, there is a case where such oscillation is produced particularly in the case of treating a large current.

### SUMMARY OF THE INVENTION

Under the consideration of the aforementioned problems, therefore, an object of the present invention is to provide a semiconductor device in which not only an insulated gate semiconductor device such as an IGBT constituting a main switching element is protected from an overcurrent, but the state where the overcurrent flows therein is excluded.

Another object of the present invention is to provide a semiconductor device having a current limiting circuit which does not cause oscillation during the current limiting operation and can stably limit the current.

To solve the above-mentioned problems, according to the first aspect of the present invention, a gate voltage of an insulated gate semiconductor device having an overcurrent limiting means is compared with a predetermined reference voltage to judge whether or not the state of the insulated gate semiconductor device is an overcurrent state to thereby make it possible to control the insulated gate semiconductor device. That is, an insulated gate semiconductor device having a driving apparatus and an overcurrent limiting means in which an overcurrent state is judged to make it possible to change a gate voltage applied to a gate electrode, according to the present invention, is characterized in that the driving apparatus has a driving means for supplying a control voltage to the insulated gate semiconductor device correspondingly to an input signal supplied to the driving apparatus, and a comparing means for comparing the gate voltage with a predetermined reference voltage. Preferably, the driving apparatus has an off signal output means for changing the input signal into an off state on the basis of a result of comparison in the comparing means. In addition, in order to soft cut off the insulated gate semiconductor device in the overcurrent state, it is effective that a soft cutting-off circuit for soft cutting-off is used as the driving means.

In the insulated gate semiconductor device having an overcurrent limiting means, the current passing through the insulated gate semiconductor device is limited by lowering the gate voltage in the case of an overcurrent state to thereby prevent the semiconductor device from damaging. Accordingly, in the overcurrent state, the gate voltage of the insulated gate semicondutor device is set to be lower than the normal gate voltage based on the on-state control voltage supplied from the driving apparatus. Accordingly, whether or not the state of the insulated gate semiconductor device is an overcurrent state, can be judged by comparing the gate voltage actually applied to the insulated gate semiconductor device with a predetermined reference voltage slightly lower than the normal gate voltage by using the comparing means.

By judging whether or not the state is an overcurrent state by using the comparing means as described above, not only an alarm can be given to the outside of the driving apparatus to turn off the input signal to the driving apparatus to cut off the insulated gate semiconductor device, but the removal of a cause for the overcurrent state can be facilitated. Accordingly, the continuous use of the insulated gate semiconductor device under the overcurrent state can be limited to protect the insulated gate semiconductor device from damaging. Of course, an off-signal output means may be provided in the driving apparatus per se to forcedly cut off the insulated gate semiconductor.device to thereby protect the insulated gate semiconductor device from an overcurrent.

According to a second aspect of the present invention, the operation of an overcurrent limiting circuit of a switching portion is judged and an input signal itself is controlled. That is, a semiconductor device comprises a switching portion provided with an insulated gate switching element controlled on the basis of a gate voltage applied from a gate driving portion, and a current limiting circuit for limiting a current flowing in the insulated gate switching element, characterized in that the semiconductor device further comprises a judgment portion for judging an operating state of the current limiting circuit, and a control portion for controlling a signal supplied to the gate driving portion on the basis of a result of the judgment in the judgment portion.

In the case where the current limiting circuit has a sense resistance means for detecting a value of the current flowing in the insulated gate switching element, a control element for bypass-controlling the gate voltage from a drop voltage across the sense resistance means, and an overcurrent detection terminal for detecting the drop voltage, it is effective that the judgment portion has a comparison means for comparing the voltage at the overcurrent detection terminal with a reference voltage. Even in the case where the current limiting circuit has no overcurrent detection terminal, the judgment portion may be formed by using a comparison means for comparing the gate voltage applied to the switching portion with a reference voltage.

It is preferable that an automatic stop control portion for converting the signal supplied to the gate driving portion into a stop signal on the basis of a result of the judgment in the judgment portion is employed as the control portion. It is also effective that an alarm control portion for producing an alarm signal on the basis of a result of the judgment in the judgment portion is employed as the control portion.

By judging the operation of the overcurrent limiting circuit portion of the switching portion in the judgment portion, whether or not the insulated gate switching element falls in a state where an overcurrent flows therein can be determined. Because the overcurrent state of the insulated gate switching element can be canceled by controlling the signal supplied to the gate driving portion on the basis of the judgment, the trouble that an overcurrent flows again due to hunting or the like can be prevented from occurring.

In the case where the current limiting circuit portion has an overcurrent detection terminal, the current flowing in the insulated gate switching element can be judged by comparing the voltage at the terminal with a reference voltage. Even in the case where the current limiting circuit portion has no overcurrent detection terminal, the ratio of the output impedance of the gate driving portion to the input impedance of the switching portion can be detected by comparing the gate voltage applied to the switching portion with a reference voltage. Because the ratio of the output impedance of the gate driving portion to the input impedance of the switching portion is changed when an overcurrent state occurs and the control element goes Into a bypass operation, the overcurrent state can be judged.

By using an automatic stop control portion as the control portion, such a protecting method that the switching portion can be automatically stopped when an overcurrent occurs can be employed.

By using an alarm control portion as the control portion, the information that the signal inputted to the gate driving portion is abnormal can be provided so that processing such as canceling of the overcurrent state, excluding the cause thereof, and so on, can be made.

According to a third aspect of the present invention, the change of gate voltage Vg for entering the operation of control when a large current flows is relaxed to prevent sudden change of a main current flowing in a switching element. That is, a semiconductor device comprises an insulated gate switching element controllable by gate voltage applied to a gate electrode thereof, a detection resistance means for detecting a current flowing through the insulated gate switching element, and a gate control element which can control the gate voltage by voltage dropped in the detection resistance moans, and is characterized by further comprising a gate control relaxation means for relaxing the change speed of the gate voltage based on the operation of the gate control element.

As the gate control relaxation means, it is preferable to use a relaxation resistance means inserted immediately before the gate electrode as a resistor against the gate voltage. In the case where the gate control element is an insulated gate control element having an insulated gate, it is effective to use a drop voltage relaxation resistance means constituted by a resistor inserted between the gate control element and the detection resistance means, or a drop voltage relaxation capacitance means constituted by a capacitor connected in parallel to the detection resistance means. Moreover, as the insulated gate switching element, it is effective to use an IGBT having a current sense terminal.

As has been described, the rate of change of the gate voltage is relaxed to prevent a sudden change of the main current in the operation of current limitation of the insulated gate switching element, so that it is possible to suppress an inductance load voltage produced by a sudden change of a current in the detection resistance means. Thus, the gate control element is not turned on suddenly and it is possible to control the gate voltage to be a value corresponding to a predetermined current limitation value through this gate control element.

In an insulated gate switching element or an insulated gate control element having an insulated gate, it is possible to control the operation speed thereof on the basis of the rate of increase of the gate voltage. Therefore, the rate of increase of the gate voltage of the insulated gate switching element can be reduced by use of a relaxation resistance means, so that it is possible to relax the response speed of the insulated gate switching element itself.

Further, if the gate control element is an insulated gate control element, the response speed of the insulated gate control element can be relaxed by use of a drop voltage relaxation resistance means or a drop voltage relaxation capacitance means. It is therefore possible to restrain the change of the gate voltage of the insulated gate switching element controlled by the gate control element, so that it is possible to relax the response speed of the insulated gate switching element.

Not to say, all these relaxation resistance means, drop voltage relaxation resistance means and drop voltage relaxation capacitance means can be provided together with each other. Moreover, by providing such relaxation means, it is also possible to prevent such a malfunction that the semiconductor device is turned off by a momentary current fluctuation.

### BRIEF DESCRIPTION OF THE DRAWINGS

Fig. 1 is a circuit diagram of a conventional apparatus capable of detecting an overcurrent,
Fig. 2 is a circuit diagram showing the configuration of an apparatus for driving an insulated gate semiconductor device using a conventional soft cutting-off circuit,
Fig. 3 is a circuit diagram showing the configuration of an insulated gate semiconductor device having an overcurrent limiting circuit, and the configuration of an apparatus for driving the same,
Fig. 4 is a timing chart showing the operation of the driving apparatus depicted in Fig. 3,
Fig. 5 is a circuit diagram showing the configuration of a conventional semiconductor device,
Fig. 6 is a circuit diagram illustrating the configuration of a conventional semiconductor device,
Fig. 7 is a graph for explaining the operation of the semiconductor device shown in Fig. 6,
Fig. 8 is a circuit diagram showing the configuration of an apparatus for driving an insulated gate semiconductor device according to a first embodiment of the present invention,
Fig. 9 is a timing chart showing the operation of the driving apparatus depicted in Fig. 8,
Fig. 10 is a circuit diagram showing the configuration of an apparatus for driving an insulated gate semiconductor device according to a second embodiment of the present invention,
Fig. 11 is a circuit diagram showing the configuration of an apparatus for driving an insulated gate semiconductor device according to a third embodiment of the present invention,
Fig. 12 is a circuit diagram showing the configuration of a semiconductor device according to a fourth embodiment of the present invention,
Fig. 13 is a circuit diagram showing the configuration of a semiconductor device according to a fifth embodiment of the present invention,
Fig. 14 is a circuit diagram illustrating the configuration of a semiconductor device according to a sixth embodiment of the present invention,
Fig. 15 is a graph for explaining the operation of the semiconductor device shown in Fig. 14,
Fig. 16 is a circuit diagram illustrating the configuration of the semiconductor device according to a seventh embodiment of the present invention, and
Fig. 17 is a circuit diagram illustrating the configuration of a semiconductor device according to a eighth embodiment of the present invention.

### DETAILED DESCRIPTION OF THE INVENTION

Preferred embodiments of the present invention will be described below with reference to the drawings.

### Embodiment 1

Fig. 8 shows the configuration of a driving apparatus of a semiconductor device according to Embodiment 1 of the present invention. In this embodiment, the driving apparatus 30 is an apparatus for driving an IGBT device 10 having a current limiting means which has been described with reference to Fig. 3. The IGBT device 10 having the current limiting circuit comprises a sense-including IGBT 2, a detection resistor 12 connected to a sense terminal E1 of the sense-including IGBT 2, an overcurrent limiting circuit 13 for lowering the gate voltage V_{G} on the basis of the voltage drop across the detection resistor 12, and a gate resistor 11 for applying the control voltage V1 supplied from the driving apparatus 30, to the gate electrode 2g of the IGBT 2. Accordingly, as described above with reference to Fig. 3, the voltage drop across the detection resistor 12 increases when an overcurrent flows in the IGBT 2. Because the overcurrent limiting circuit 13 operates as a result, the gate voltage VG can be lowered to suppress the overcurrent. Detailed operations of these parts, and so on, are the same as described previously, to that those parts are designated by the same numbers and description about them is omitted.

The driving apparatus 30 of this embodiment for driving the IGBT device 10 having the above-mentioned overcurrent limiting circuit, comprises: a photo coupler 6 for supplying an input signal I received at an input terminal I1 to a driving circuit 20 while isolating the input signal I; a driving circuit 20 for outputting a control voltage V1 for controlling the IGBT device 10 on the basis of the input signal I; a comparing circuit 40 for comparing the gate voltage V_{G} with a predetermined reference voltage V0 to thereby judge whether or not the state is an overcurrent state; and an alarm signal generating circuit 50 for supplying an alarm signal from the driving apparatus 30 on the basis of the result of the comparing circuit 40.

First, the comparing circuit 40 in the driving apparatus 30 of this embodiment is constituted by a comparator 41 for comparing the gate voltage V_{G} with the reference voltage V0. The gate voltage V_{G} at the downstream side of the gate resistance 11 of the IGBT device 10 is supplied to an inverted input of the comparator 41. A high voltage V_{cc} which is supplied to the IGBT device 10 as a control voltage V1 when the input signal 1 is on, is supplied through a resistor 42 to a non-inverted input 41a. The non-inverted input 41a is connected to a low-voltage-side load terminal P2 of the IGBT device 10 through a Zener diode 43 which is a constant-voltage diode. Accordingly, the reference voltage V0 determined by the Zener diode 43 is applied to the non-inverted input 41a of the comparator 41. In the above-mentioned comparing circuit 40, when the reference voltage V0 is set to be slightly lower than the gate voltage V_{G} set by the control voltage V1, the level of an output 41c of the comparator 41 becomes low because the gate voltage V_{G} is higher than the reference voltage V0 in a normal on state. On the contrary, in an overcurrent state, the gate voltage V_{G} becomes higher than the reference voltage V0, so that a comparing circuit in which the level of the output 41c of the comparator 41 becomes high in an overcurrent state can be provided.

The alarm signal generating circuit 50 in this embodiment is constituted by a high-frequency filter 51 to which the output 41c of the comparator 41 of the comparing circuit 40 is supplied, a photo coupler 52 for insulating an output of the high-frequency filter 51, and an NAND gate 54 to which an output of the photo coupler 52 is supplied through wave-shaping inverters 53a and 53b. The input signal I is also supplied to the NAND gate 54. An output of the NAND gate 54 is further connected to an alarm signal output terminal A1. Accordingly, when, in this alarm signal generating circuit 50, the gate voltage V_{G} becomes lower than the reference voltage V0 under the condition where the level of the input signal I is high to show an on state, an ARM (bar) signal in which the output from the NAND gate 54 is inverted to a low level can be outputted. The high-frequency filter 51 is inserted so that the alarm signal generating circuit 50 does not operate at the time of the switching of the IGBT device 10. Accordingly, even in the case where pulses of 2 to 5 µs are outputted from the comparator 41 at the time of the switching of the IGBT device 10, there is no signal supplied to the alarm signal generating circuit 50 from the high-frequency filter 51.

The operation of the apparatus of this embodiment will be described with reference to a timing chart shown in Fig. 9. When first the level of the input signal which has been low becomes high at a point of time t11, the control voltage V1 of a high voltage from the driving circuit 20 is supplied to the IGBT device 10.

Hence, the gate voltage V_{G} of a high level is applied to the gate electrode 2g of the IGBT 2, so that the IGBT 2 is turned on. At this time, the gate voltage V_{G} becomes higher than the reference voltage V0, so that the level of the comparator output 41c of the comparing circuit 40 becomes low. Accordingly, because the level of a signal supplied to the NAND gate 54 through the high-frequency filter 51 and the like becomes low and at the same time the input signal I supplied to the NAND gate 54 is high, the level of an output from the NAND gate 54 becomes high. Accordingly, the signal which appears at the alarm signal output terminal Al is in a high level showing a normal state.

When the current I_{c} passing through the IGBT 2 becomes an overcurrent by some cause at a point of time t12, the overcurrent limiting circuit 13 of the IGBT device 10 operates to lower the gate voltage V_{G}. Hence, the gate voltage V_{G} becomes lower than the reference voltage V0, so that the output of the comparator 41 is inverted to a high level. Accordingly, the levels of the two signals supplied to the NAND gate 54 become high, so that the ARM (bar) signal from the NAND gate 54 becomes a low level showing an abnormal state.

Then, when the input signal I then becomes a low level showing an off state at a point of time t13, the control voltage V1 supplied from the driving circuit 20 becomes low. As a result, the gate voltage V_{G} also becomes low, so that the IGBT device 10 is stopped.

As has been described above, the driving apparatus 30 of this embodiment can judge whether or not the state of the IGBT device is an overcurrent state on the basis of comparison between the gate voltage V_{G} of the IGBT device 10 and the reference voltage V0 and can generate an alarm signal such as an ARM (bar) signal in the case of an overcurrent state. Accordingly, based on the alarm signal from the driving apparatus 30, the cause of the overcurrent can be solved, or the IGBT device 10 can be stopped by turning the state of the input signal I to the driving apparatus 30 into an off state. As has been described above, by using the driving apparatus 30 of this embodiment, it is possible to avoid a risk of damaging the IGBT 2, and the like which may be brought by the continuous operation of the IGBT device 10 under an overcurrent state.

Further, in the driving apparatus of this embodiment, the possibility of malfunction is little because the overcurrent state is judged by using, not the source voltage loaded on the IGBT as shown in Fig. 2, but the gate voltage being stable as a control voltage. Furthermore, the high-frequency filter is used in the apparatus of this embodiment in order to avoid malfunction at the time of starting-up, so that higher reliability can be secured.

### Embodiment 2

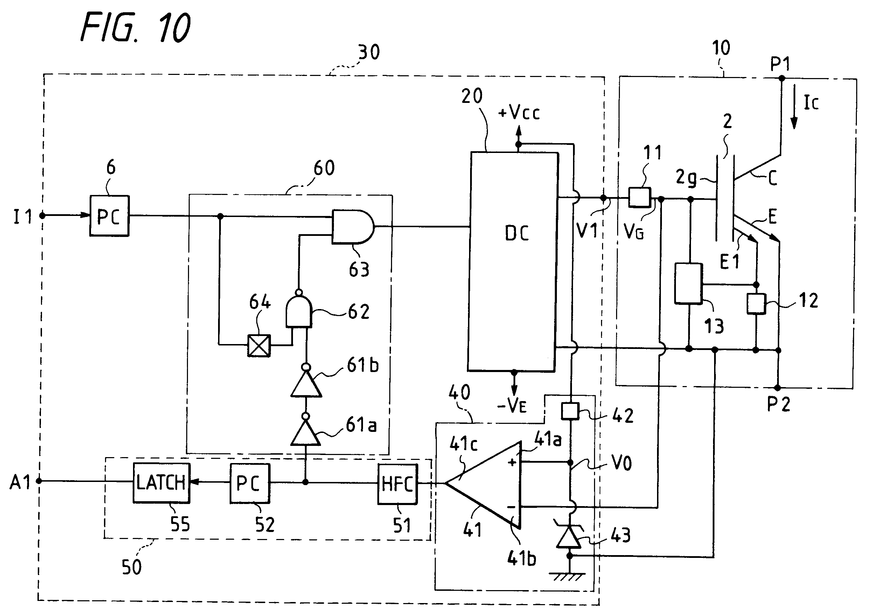

Fig. 10 shows the configuration of an apparatus for driving an insulated gate semiconductor device according to Embodiment 2. The driving apparatus 30 of this embodiment is also an apparatus for driving an IGBT device 10 having current limiting circuit as in the embodiment 1. Accordingly, the IGBT device 10 also has the sense-including IGBT 2, the detection resistor 12, the overcurrent limiting circuit 13, and the gate resistor 11. The operations of these parts, and the like, are the same as those described previously, and the detailed description thereof will be omitted.

Similarly to the driving apparatus of Embodiment 1, the driving apparatus 30 of this embodiment for driving the IGBT device 10 comprises a photo coupler 6 for inputting an input signal I supplied at an input terminal I1, to a driving circuit 20 while insulating the input signal I, a driving circuit 20 for outputting a control voltage V1 for controlling the IGBT device 10 on the basis of the input signal I, a comparing circuit 40 for comparing the gate voltage V_{c} with a reference voltage V0 to thereby judge whether or not the state is an overcurrent state, and an alarm signal generating circuit 50 for generating an alarm signal from the driving apparatus 30 on the basis of the result of the comparing circuit 40. A point to be noticed in the driving apparatus 30 of this embodiment is in that, in addition to these circuits, an off-signal output circuit 60 for supplying an off signal to the driving circuit 20 is provided.

The configuration of the driving circuit 20 and the comparing circuit 40 among these circuits is the same as that described in Embodiment 1, so that the same parts are designated by the same numbers and the description thereof is omitted. On the other hand, the alarm signal generating circuit 50 is constituted by a high-frequency filter 51 to which an output from the comparator 41 of the comparing circuit 40 is supplied, a photo coupler 52 for supplying a signal passing through the high-frequency filter to a latch circuit 55 while insulating the signal, and a latch circuit 55 for latching the alarm signal passing through the high-frequency filter 51 to output the signal from the alarm signal output terminal A1. Accordingly, in the driving apparatus 30 of this embodiment, an alarm signal which is in a high level when the gate voltage V_{G} is lower than the reference voltage V0 reversely to Embodiment 1, that is, when the IGBT device 10 is in an overcurrent state, can be supplied from the alarm signal output terminal A1.

Further, in the driving apparatus 30 of this embodiment, the off-signal outputting circuit 60 for supplying an off signal to the driving circuit 20 to automatically stop this apparatus at the time of the overcurrent state of the IGBT device 10 is provided. The off-signal output circuit 60 is constituted by inverters 61a and 61b for wave-shaping the signal passing through the high-frequency filter 51 of the alarm signal output circuit 50, an NAND gate 62 to which output from the inverters 61a and 61b and the input signal I are supplied, and an AND gate 63 to which an output from the NAND gate 62 and the input signal I are supplied. An output of the AND gate 63 is connected to an input of the driving circuit 20. The input signal I is supplied to the NAND gate 62 through a delay circuit 64, so that a signal of an on-state signal can be supplied to the driving circuit 20 when the input signal I is inverted from an on state to an off state.

That is, in the driving apparatus 30 of this embodiment, having the off-signal output circuit 60, the output of the NAND gate circuit 62 changes in the same manner as in the ARM (bar) signal described in Fig. 9. Accordingly, when the input signal I is turned on at a point of time t11 in Fig. 9, the level of the output of the comparator 41 is high but the level of the input signal I is low because of the delay circuit 64. The high-level output from the NAND gate circuit 62 is maintained and the level of the output from the AND gate circuit 63 is inverted from a low level into a high level. Accordingly, the IGBT device 10 is turned on on the basis of the driving circuit 20. When the IGBT device then falls in an overcurrent state at a point of time t12, the output of the NAND gate circuit 62 is inverted to a low level. Accordingly, an off signal is supplied to the driving circuit 20 from the AND gate circuit 63, so that the IGBT device 10 is turned off. On the other hand, an alarm signal of a high level from the alarm signal generating circuit 50 is supplied to the alarm signal output terminal A1. Accordingly, the IGBT device 10 can be self-cut off by using the driving apparatus 30 of this embodiment when the IGBT device 10 falls in an overcurrent state, so that the IGBT 2 can be prevented from damaging. At the same time, an indication of the overcurrent state can be outputted to external apparatuses through the alarm signal output terminal Al to carry out processing such as removal of the cause of the overcurrent state.

### Embodiment 3

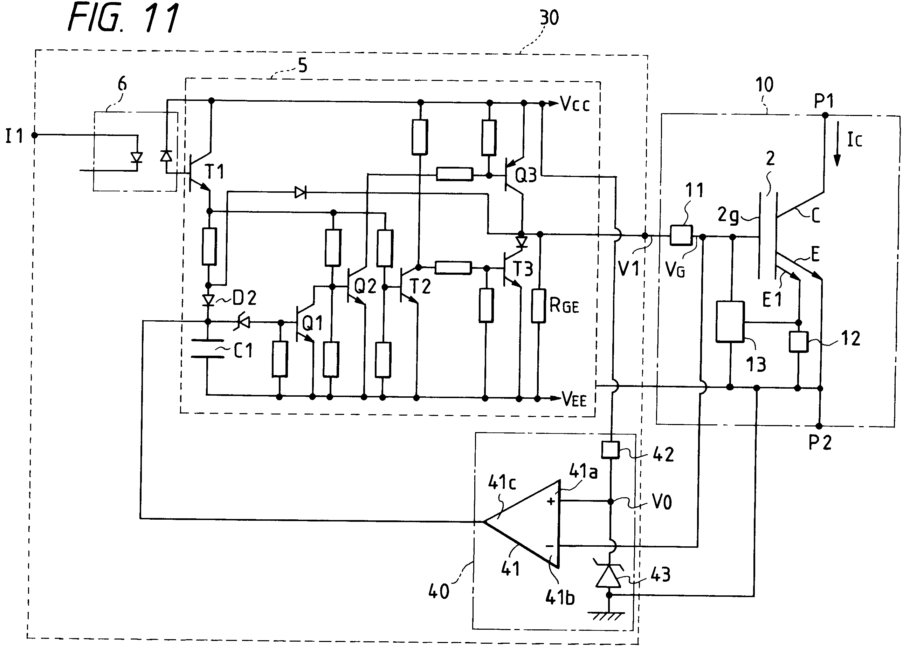

Fig. 11 shows the configuration of an apparatus 30 for driving an insulated gate semiconductoi device according to embodiment 3 of the present invention. The driving apparatus 30 of this embodiment is also an apparatus for driving an IGBT device 10 having current limiting circuit as in Embodiment 1. Accordingly, the IGBT device 10 also has the sense-including IGBT 2, the detection resistor 12, the overcurrent limiting circuit 13, and the gate resistor 11. The operations of these parts, and the like, are the same as those described previously, so that detailed description thereof will be omitted.

Similarly to the driving apparatus of Embodiment 1, the driving apparatus 30 of this embodiment for driving the IGBT device is an apparatus having a comparing circuit 40 for comparing the gate voltage VG with a reference voltage V0 to thereby judge whether or not the state is an overcurrent state. A soft cutting-off circuit 5 for soft cutting off the IGBT device on the basis of a signal from the comparing circuit 40 is used as the driving circuit. This soft cutting-off circuit 5 has the same configuration as that in the circuit described previously with reference to Fig. 2. Accordingly, the same parts are designated by the same numbers, and the description of the configuration and operation thereof will be omitted.

In the driving apparatus 30 of this embodiment, the output of the comparator 41 of the comparing circuit 40 is connected to the base of the transistor Q1 in the soft cutting-off circuit 5. Accordingly, when the IGBT device 10 is in a normal state, that is, when the gate voltage V_{c} is higher than the reference voltage V0, the level of the output of the comparator 41 is low so that the transistor Q3 is kept in an on state without increase of the base voltage of the transistor Q1 even by the input signal I from the photo coupler 6 through the diode D2. Accordingly, the soft cutting-off does not operate, so that the IGBT device 10 is controlled on the basis of the input signal I supplied through the photo coupler 6.

On the contrary, when the IGBT device 10 falls in an overcurrent state, the gate voltage V_{G} becomes lower than the reference voltage V0 so that the output of the comparator 41 is inverted to a high level. Accordingly, the base voltage of the transistor Q1 in the soft cutting-off circuit is made high, so that the transistor Q1 is turned on. Hence, the transistor Q3 is turned off, so that the gate voltage V_{G} is gradually reduced through the cutting-off resistors R_{GE} to make it possible to soft cut off the IGBT device 10. Because in the driving apparatus 30 of this embodiment the output of the comparator 41 is supplied to the soft cutting-off circuit 50, a circuit of the insulated class corresponding to the output voltage of the comparator 41 substantially similar to the voltage used in a control circuit for a semiconductor device can be employed. Accordingly, there is no necessity of employing a circuit of a high insulated class to cope with a high voltage applied to the IGBT 2 as in the prior art type driving apparatus described previously with reference to Fig. 2.

Further, because in the driving apparatus 30 of this embodiment the overcurrent state is judged by comparing the gate voltage being stable as a control voltage, the possibility of malfunction is very little compared with the apparatus of the type making such judgment by the source voltage loaded on the IGBT as in the prior art type soft cutting-off circuit shown in Fig. 2.

As has been described above, the IGBT device 10 can be self-cut off by using the driving apparatus 30 of this embodiment when the IGBT device falls in an overcurrent state, so that disadvantages such as damage caused by the continuous operation under the overcurrent state, and the like, can be prevented from occurring. Further, because, in the driving apparatus 30 of this embodiment, the IGBT device 10 is cut off by using the soft cutting-off circuit 5, the IGBT device can be cut off while the current passing through the IGBT 2 is gradually reduced even in the case where the IGBT device 10 is to be turned off in the condition that the IGBT device falls in an overcurrent state. Accordingly, production of noise, and the like, caused by the rapid cutting-off of the IGBT device 10 can be suppressed, so that the influence on external apparatus can be prevented. further, because the soft cutting-off circuit 5 can be constituted by a circuit of a normal voltage level, the driving apparatus can be reduced in size and can be produced at low cost.

As has been described above, the driving apparatus according to the present invention can drive an insulated gate semiconductor device having an overcurrent limiting means, in which whether or not the state of the insulated gate semiconductor device is an overcurrent state can be judged by comparing the gate voltage of the insulated gate semiconductor device with a predetermined reference voltage by using a comparing means. Accordingly, it is possible to exclude the cause of the overcurrent state through issuing an alarm signal to the outside on the basis of a signal given from the comparing means or to self-cut off the insulated gate semiconductor device by the driving apparatus per se by using means for outputting an off signal given from the comparing means. Hence, by using the driving apparatus of there embodiments 1 to 3, the situation that the insulated gate semiconductor device is continuously used under the overcurrent state can be avoided, so that the insulated gate semiconductor device can be protected from damaging and the like.

Further, in the driving apparatus of these embodiments, the driving apparatus can be simplified in configuration by connecting a comparing means and a soft cutting-off circuit even in the case where the soft cutting-off circuit is used to make self-cutting. furthermore, so high insulating characteristic as required in the prior art is not required for constituting the soft cutting-off circuit. Consequently, a driving apparatus in which not only the insulated gate semiconductor device can be protected from damaging due to overcurrent but production of noise, and the like, at the time of the self-cutting-off can be suppressed, can be provided as a low-cost apparatus and as a small-size apparatus.

### Embodiment 4

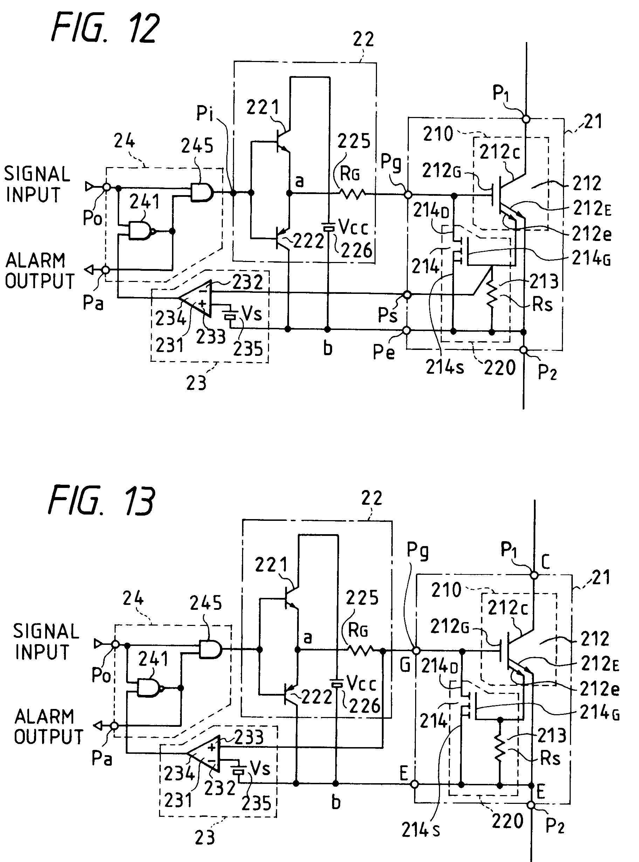

Fig. 12 shows the configuration of a semiconductor device according to Embodiment 4 of the present invention. The device of this embodiment is a semiconductor device having a switching portion 21 using an IGBT 212, as in the conventional device described above with reference to Fig. 5. Also in this embodiment, the IGBT 212 is provided with a current-sense IGBT and has a current limiting circuit 220 constituted by a sense resistor 213 connected to a sense emitter terminal 212c of the IGBT, and an MOSFET 214 which is a control element for controlling the gate voltage on the basis of the drop voltage across the sense resistor 213. Also similarly to the conventional device, a gate driving circuit 22 for driving the switching portion 21 on the basis of a gate voltage signal Vg has an NPN transistor 221 as an on-side output switch, a PNP transistor 222 as an off-side output switch, a gate resistor RG, and a source voltage Vcc 226. Accordingly, parts the same as those in the conventional device are designated by the same numbers, and the description about the configuration and operation thereof will be omitted.

In the device of this embodiment, a judgment circuit 23 for confirming the operation of the current limiting circuit 220 of the switching portion 21 and a control circuit 24 for controlling the signal supplied to the gate driving circuit 22 are provided in addition to the switching portion 21 and the gate driving circuit 22. In the switching portion 21, a detection terminal Ps for detecting the voltage produced across the sense resistor 213 is provided in addition to the terminals of the conventional switching portion 21.

First, the judgment circuit 23 is constituted by a comparator 231. A non-inverted input 232 of the comparator 231 is connected to the detection terminal Ps of the switching portion 21. A constant-voltage source 235 for forming a reference voltage Vs is connected to an inverted input 233 of the comparator 231. Accordingly, the operating state of the current limiting circuit 220 can be judged by setting the reference voltage Vs to be equal to the threshold of the MOSFET 214. That is, in the case where the drop voltage across the sense resistor 213 is lower than the reference voltage Vₛ, the level of the output 234 of the comparator 231 is low. When the current passing through the IGBT 212 exceeds a predetermined current value so that the drop voltage across the sense resistor 213 becomes higher than the reference voltage Vs, the level of the output 234 of the comparator 231 is inverted into a high level. In the current limiting circuit 220, at this time, the MOSFET 214 becomes conductive so that the limiting operation is started. Accordingly, the operating state of the current limiting circuit 20, that is, whether or not the IGBT falls in a state where an overcurrent flows therein, can be judged by comparing the drop voltage across the sense resistor 213 with the reference value through the comparator 231.

The control circuit 24 which is a circuit for performing processing such as controlling of the input signal, and the like, on the basis of a result of the judgment in the judgment circuit 23, is constituted by a two-input NAND gate 41 to which the output of the comparator 231 and the input signal supplied to an input terminal P0 of the control circuit are supplied, and an AND gate 245 to which the output of the NAND gate 241 and the input signal supplied to the input terminal P0 are supplied. An output signal from the NAND gate 241 is supplied to an input terminal Pi of the gate drinving circuit 22. Accordingly, the level of the output of the NAND gate 241 becomes low when the output from the comparator 231 is in a high level indicating an overcurrent operating state and at the same time the input signal is in a high level. Therefore, when an overcurrent operating state is established though the level of the input signal is high, the level of the output of the AND gate 245 becomes low so that the signal supplied to the gate driving circuit 22 becomes a low level indicating an off state. Accordingly, the gate voltage signal applied to the switching portion 21 is lowered to turn off the IGBT 212 so that the state where an overcurrent flows therein can be canceled.

When, on the contrary, the level of the,output of the comparator 231 is low, that is, when the overcurrent limiting circuit is not operative, the level of the output of the NAND gate 241 is kept high irrespective of the input signal. Accordingly, the input signal is supplied to the gate driving circuit 22 without any change, so that the switching portion 21 makes its operation normally.

In the control circuit 24 in this embodiment, the output of the NAND gate 241 is connected to an alarm output terminal Pa so that an alarm signal can be produced when the overcurrent limiting circuit is operative in the condition that the input signal is on. Accordingly, in an operator or a higher-rank controller, the signal supplied to the input terminal P0 of the control circuit 24 can be turned off or the cause of the overcurrent state can be eliminated, on the basis of the alarm signal.

Because in the device of this embodiment the signal supplied to the gate driving circuit 22 can be controlled on the basis of the judgment that the switching portion 21 goes into an overcurrent limiting operation, the situation that an overcurrent passing through the switching portion flows can be avoided. Furthermore, the situation that an overcurrent flows again on the basis of oscillation of the current value caused by the current limiting circuit 220 can be avoided. In addition, because an alarm signal can be generated, an operator or a higher-rank controller can confirm that an overcurrent flows. Accordingly, it is possible to use this device for prevention of the overcurrent state from occurring again.

### Embodiment 5

Fig. 13 shows the configuration of the semiconductor device according to Embodiment 5 of the present invention. Similarly to the embodiment 4, the device of this embodiment is a semiconductor device having a switching portion 21 using an IGBT 212 with a sense emitter terminal 212c and has a current limiting circuit 220 for preventing the element from destruction, and the like, caused by an overcurrent. The device further has a gate driving circuit 222 using transistors 221 and 222 and the like, a judgment circuit 223 for judging the operating state of the current limiting circuit 220, and a control circuit 20. Accordingly, parts the same as those in the conventional device are designated by the same numbers, and the description about the configuration and operation thereof will be omitted.

A point to be noticed in the device of this embodiment, different from the Embodiment 4, is in that the same as the conventional switching portion shown in Fig. 5 is used as the switching portion 1 without constituting any detection terminal Ps. In this embodiment, therefore, the input terminal Pg of the switching portion 21 to which the gate driving voltage signal is supplied is connected to the non-inverted input 233 of the comparator 231 so that the judgment circuit 23 judges the operating state of the current limiting circuit on the basis of the drop of the input impedance at the switching portion 21. That is, when the signal supplied to the input terminal P1 of the gate driving circuit 22 is on, a predetermined voltage signal is supplied to the input terminal Pg of the switching portion 21 from the gate driving circuit 22 on the basis of the driving voltage vcc. In the case where the current limiting circuit 220 is not operative, the electric potential of the input terminal Pg is determined on the basis of the input impedance of the switching portion 21 due to the IGBT 212 and the output impedance of the gate driving circuit 22 due to the gate resistor 225. When the current limiting circuit 220 operates now, the MOSFET 214 becomes conductive. As a result, the input impedance of the switching portion 21 is reduced, so that the electric potential of the input terminal Pg is lowered. Accordingly, when the electric potential of the input terminal Pg is lowered so as not to be larger than the reference voltage vs applied to the non-inverted input of the comparator 231, the output 234 of the comparator 231 is inverted so as to have a low level.

As has been described above, in the judgment circuit 23 in the device of this embodiment, the operating state of the current limiting circuit 220 can be judged by changing the electric potential of the input terminal Pg based on the lowering of the input impedance of the switching portion 21, so that whether or not the IGBT 212 falls into a state where an overcurrent flows therein can be detected. Accordingly, the same configuration as in the prior art can be applied to the switching portion 1 so that it is not necessary to provide any new detection terminal additionally. Accordingly, in the device of this embodiment, a function of detecting an overcurrent to thereby automatically cut off the IGBT can be provided simply by adding the judgment circuit 23 and the control circuit 24 to the device. Further, it is possible to output an alarm signal so that the overcurrent state is suitably controlled. As has been described above, in the device of this embodiment, not only wiring to the detection terminal can be omitted but the above-mentioned function can be provided additionally in the simplified form. Accordingly, it is possible to use a package having no terminal other than the collector, gate and emitter terminals as in the prior art.

Although these embodiments 4 and 5 have been described about the case where the IGBT is employed as a switching element of the switching portion, it is a matter of course that the IGBT may be replaced by an insulated gate semiconductor device such as a power MOSFET, or the like. Although these embodiments have been described about the case where the MOSFET is employed as a control element in the current limiting circuit, the MOSFET may be replaced by a device such as a thyristor, a bipolar transistor, or the like. Furthermore, it is a matter of course that the bipolar transistor used in the gate driving circuit may be replaced by a switching device such as an MOSFET, or the like. Furthermore, the comparator used as the judgment circuit may be replaced by a device such as an inverter having a predetermined threshold voltage, or the like. In addition, it is a matter of course that any one of various logics may be incorporated as the logic used in the control circuit.

As has been described above, in the semiconductor device according to these embodiments 4 and 5, whether or not the switching portion falls in a state where an overcurrent flows therein, is judged in the judgment portion on the basis of the operation of the current limiting circuit for limiting a current in the case where an overcurrent flows. In the control portion, the signal supplied to the switching portion can be changed on the basis of the judgment, so that processing such as cutting-off of the overcurrent, or the like, can be performed in the switching portion. Accordingly, in the semiconductor device of this embodiment, the state where an overcurrent flows can be prevented from being continued. Furthermore, the situation that oscillation of the current value or flowing of an overcurrent is caused by the operation of the current limiting circuit can be avoided in the switching portion.

Furthermore, in the semiconductor device according to these embodiments, an alarm signal can be generated easily when a state where an overcurrent flows occurs. Accordingly, on the basis of the alarm signal, the control state can be changed or the overcurrent state can be detected to examine the cause thereof.

In addition, the operating state of the overcurrent limiting portion can be judged on the basis of the input impedance of the switching portion, so that the above-mentioned function can be provided in the device without providing any change of the switching portion used in the prior art. Accordingly, the time and cost required for developing a new device can be saved so that a semiconductor device of a higher function can be provided though it is simple in configuration.

### Embodiment 6

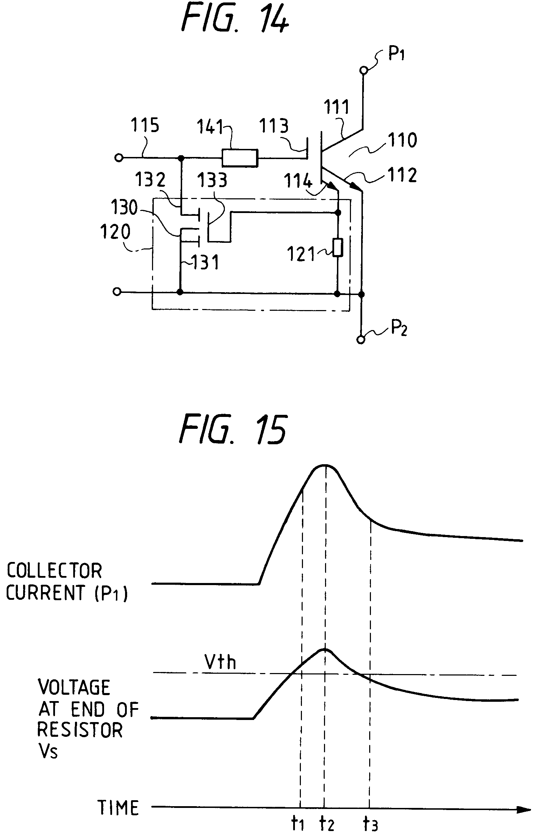

Fig. 14 shows a configuration of a semiconductor device having a current limitation circuit 120 according to embodiment 6 of the present invention. The device in this embodiment is also a power semiconductor device using an IGBT 110 as a switching element similarly to the conventional semiconductor device shown in Fig. 6. Further, the IGBT 110 of the device in this embodiment also includes a semiconductor emitter 114 for current detection in addition to an emitter 112. This sense emitter 114 is connected through a current sense resistor 121 to an external terminal P2 which becomes a low electric potential, so that a current limitation circuit 120 is driven in response to a voltage drop across this current sense resistor 121 to thereby limit an overcurrent flowing into the IGBT 110, in the same manner as in the conventional semiconductor device shown in Fig. 6. Therefore, parts the same as those in the conventional device are designated by the same numbers, and their description will be omitted.

A remarkable point in the semiconductor device in this embodiment is that a relaxation resistor 141 as a resistor for relaxing a change in gate voltage applied to a gate electrode 113 of the IGBT 110 is provided in a gate driving circuit 115. This relaxation resistor 141 is inserted immediately before the gate electrode 113 so that the change of the gate voltage applied to the gate electrode 113 can be suppressed. That is, the IGBT is a voltage driven element driven by a voltage applied to the insulated gate electrode 113, and its response speed can be controlled by the rate of change (dVg/dt) of the gate voltage Vg in the gate electrode 113. Therefore, by the provision of the relaxation resistor 141 for limiting the current value to be transmitted to the gate electrode 113, the rate of charge/discharge of the gate electrode 113 can be relaxed to thereby delay the rate of change of the gate voltage Vg applied to the IGBT 110. Thus, it is possible to relax the response speed of the IGBT 110.

Fig. 15 shows a collector current flowing in an external P1, and a drop voltage Vs produced across the current sense resistor 121 in the case where a large current flows in the device of this embodiment. In the same manner as in the conventional semiconductor device shown in Fig. 6, if a large current flows into the IGBT 110, a current proportional thereto flows from the sense emitter 114, and the drop voltage Vs across the current sense resistor 121 becomes high. At a point of time t1, if the drop voltage Vs is over a threshold voltage Vth of an MOSFET 130, the MOSFET 130 is turned on. Although the collector current begins to decrease thereafter at a point of time t2 when a slight overcurrent flows because of the response delay of the operation of the MOSFET 130, the response speed of the IGBT 110 is relaxed in the device of this embodiment so that the inductance load voltage, ℓ x di/dt, produced by the time differential (di/dt) of the change of the collector current is small. There is therefore no fear that the MOSFET 130 is biased forward, and hence there is no case that the IGBT 110 is turned off. The current controlled by the IGBT 110 becomes lower gradually, and the drop voltage Vs also becomes lower with together.

At a point of time t3, the bypass quantity of the MOSFET 130 driven on the basis of the drop voltage Vs balances with the passing current quantity of the IGBT 110 controlled by the bypassed gate voltage vg, so that a current with limited value flows into the IGBT 110.

As has been described above, in the semiconductor device having a current limitation circuit according to this embodiment, it is possible to delay the response of the IGBT 110 by means of a relaxation resistor inserted immediately before the gate electrode 113. Therefore, the current limitation operation in the IGBT 110 is relaxed so that it is possible to prevent sudden drop or oscillation in a current as in the conventional device. further, since sudden drop or oscillation in a current is prevented, it is possible to omit the reverse-current blocking diode 135 inserted between the MOSFET 30 and the gate driving circuit 115 in the conventional device.

### Embodiment 7

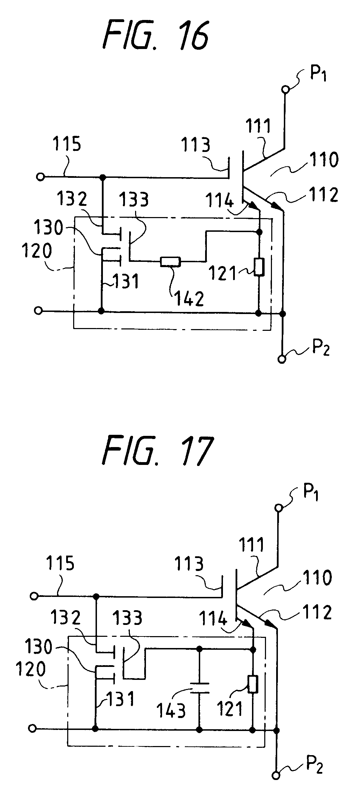

Fig. 16 shows a configuration of a semiconductor device having a current limitation circuit 120 according to embodiment 7. The device of this embodiment is also a power semiconductor device using, as a switching element, an IGBT 110 having a sense emitter 114 for current detection in the same manner as in the semiconductor device which has been described above. A current limitation circuit 120 for limiting a passing current of the IGBT 110 which flows through a current sense resistor 121 from this sense emitter 114 is constituted in the same manner as above in Embodiment 6. In this embodiment, therefore, parts the same as those in Embodiment 6 are designated by the same numbers, and their description will be omitted.

A remarkable point in the semiconductor device of this embodiment is that a resistor 142 is provided in a circuit for applying a drop voltage across the current sense resistor 121 to a gate electrode 133 of a MOSFET 130. This resistor 142 is a resistor for relaxing the operation of the MOSFET 130, so that the rate of charge/discharge of the gate electrode 133 of the MOSFET 130 which is a voltage driven element like an IGBT can be reduced to relax the response speed of the MOSFET 130. Therefore, the rate of change of the gate voltage Vg controlled and bypassed by this MoSFET 130 is also relaxed, so that the response speed of the IGBT 110 is also delayed. Therefore, in the same manner as in Embodiment 6, the current limitation operation in the IGBT 110 is delayed to thereby suppress the generation of the inductance load voltage. Therefore, in the same manner as in Embodiment 6, there is no fear that the MOSFET 130 is biased forward, and hence there is no case where a current is lowered suddenly or oscillated.

### Embodiment 8

Fig. 17 shows a structure of a semiconductor device according to embodiment 8. The semiconductor device of this embodiment also includes a current limitation circuit 120 and an IGBT 110 having a sense emitter 114 for current detection in the same manner as in the semiconductor devices which have been described above. In this embodiment, therefore, parts the same as those in the above embodiments are designated by the same numbers, and their description will be omitted.

A remarkable point in the semiconductor device of this embodiment is that a capacitor 143 is connected in parallel to a current sense resistor 121. This capacitor 143 is a capacitor for relaxing the operation of a MOSFET 130, so that the time to charge a circuit continued to a gate electrode 33 of the MOSFET 130 is prolonged by a drop voltage produced across the current sense resistor 121, to thereby delay the response speed of the MOSFET 130. That is, in the same manner as in Embodiment 7, the rate of charge/discharge of the gate electrode 133 of the MOSFET 130 is reduced by this capacitor 143, so that it is possible to relax the response speed of the MOSFET 130. Therefore, the response speed of the IGBT 110, the gate voltage of which is controlled by this MOSFET 130, is also delayed, so that sudden lowering or oscillation in a current value can be prevented from occurring. Thus, it is possible to ensure a stable current limitation operation.

Although a device using an IGBT as a switching element has been described in the above embodiments 6 to 8, various insulated gate switching elements such as power MOSFETs and so on can be used as switching elements. further, not to say, an MOSFET as a control element for controlling and bypassing a gate voltage which drives such a switching element can be replaced by an insulated gate element such as an IGBT or the like. Further, in the case of inserting a relaxation resistor immediately before a switching element as shown in Embodiment 6, an element such as a bipolar transistor, a thyristor, or the like, may be used as a control element.

As has been described above, in the semiconductor device according to the embodiments 6 to 8 of the present invention, the rate of change of the gate voltage of a switching element for performing a current limiting operation is relaxed to thereby delay the response speed of the, limitation operation, and thereby suppress the production of a voltage caused by the inductance load produced in a detection resistance means. Therefore, a control element for controlling the gate voltage is not turned on suddenly, so that it is possible to prevent sudden lowering or oscillation of the current in the switching element. In the semiconductor device according to the present invention, therefore, even in the case of treating a large current, it is possible to ensure a stable operation of current limitation, and hence it is possible to surely prevent elements from being broken by an overcurrent.

Further, by setting the response speed of a switching element to be larger than the time of change of a main current treated in this semiconductor device, it is possible to prevent such a malfunction in which the oscillation of the main current is erroneously amplified, or the main current is cut off by a momentary overcurrent. By use of the semiconductor device according to the present invention, therefore, it is possible to realise a semiconductor device having a stable protective function and a high reliable switching function.

## Claims

1. A semiconductor device, comprising:
an insulated gate semiconductor portion having a gate electrode;
an overcurrent limiting means for judging an overcurrent state of said insulated gate semiconductor portion to make it possible to change a gate voltage applied to said gate electrode; and
a driving portion for driving said insulated gate semiconductor portion;
wherein said driving portion comprises;
a driving means for supplying a control voltage to said insulated gate semiconductor portion correspondingly to an input signal supplied to said driving portion; and
a comparing means for comparing said gate voltage with a predetermined reference voltage.

2. A semiconductor device as claimed in claim 1, wherein said driving portion further comprises an off signal output means for changing said input signal into an off state on the basis of a result of compariSon by said comparing means.

3. A semiconductor device as claimed in claim 1 or 2, wherein said driving means is a soft cutting-off circuit for performing soft cutting-off.

4. A semiconductor device, comprising:
a gate driving portion for supplying a gate voltage;
a switching portion including an insulated gate switching element controlled on the basis of said gate voltage from said gate driving portion, and a current limiting circuit for limiting a current flowing in said insulated gate switching element;
a judgement portion for judging an operating state of said current limiting circuit; and
a control portion for controlling a signal supplied to said gate driving portion on the basis of a result of the judgement in said judgement portion.

5. A semiconductor device as claimed in claim 4, wherein said current limiting circuit includes a sense resistance means for detecting a value of a current flowing in said insulated gate switching element, a control element for bypass-controlling said gate voltage through a drop voltage across said sense resistance means, and an overcurrent detection terminal for detecting said drop voltage; and said judgement portion includes a comparison means for comparing a voltage at said overcurrent detection terminal with a reference voltage.

6. A semiconductor device as claimed in claim 4, wherein said current limiting circuit includes a sense resistance means for detecting a value of the current flowing in said insulated gate switching element, and a control element for bypass-controlling said gate voltage through a drop voltage across said sense resistance means; and said judgement portion includes a comparison means for comparing said gate voltage applied to said switching portion with a reference voltage.

7. A semiconductor device as claimed in claim 4, 5 or 6, wherein said control portion includes an automatic stop control portion for converting said signal supplied to said gate driving portion into a stop signal on the basis of a result of the judgement in said judgement portion.

8. A semiconductor device as claimed in claim 4, 5 or 6, wherein said control portion includes an alarm control portion for producing an alarm signal on the basis of a result of the judgement in said judgement portion.

9. A semiconductor device, comprising:
an insulated gate switching element controllable by a gate voltage applied to a gate electrode thereof;
a detection resistance means for detecting a current flowing through said insulated gate switching element;
a gate control element for controlling said gate voltage by a voltage drop in said detection resistance means; and
a gate control relaxation means for relaxing a rate of change of said gate voltage based on the operation of said gate control element.

10. A semiconductor device as claimed in claim 9, wherein said gate control relaxation means is a relaxation resistance means inserted immediately before said gate electrode as a resistor for said gate voltage.

11. A semiconductor device as claimed in claim 9, wherein said gate control element is an insulated gate control element having an insulated gate, and said gate control relaxation means is a drop voltage relaxation resistance means constituted by a resistor inserted betweens said gate control element and said detection resistance means.

12. A semiconductor device as claimed in claim 9, wherein said gate control element is an insulated gate control element having an insulated gate, and said gate control relaxation means is a drop voltage relaxation capacitance means constituted by a capacitor connected in parallel to said detection resistance means.

13. A semiconductor device as claimed in any one of claims 9, 10, 11 and 12, wherein said insulated gate switching element is an insulated gate bipolar transistor having a current sense terminal.
